# EUROPEAN PATENT APPLICATION

(11) **EP 1 521 361 A1**
(43) Date of publication of application: **06.04.2005**
(21) Application number: 03022325.9
(22) Date of filing: 04.10.2003
(51) Int. Cl.: H03F 3/60, H03F 1/02

(54) **Modular amplifier arrangement**

(71) Applicant: Lucent Technologies Network Systems GmbH, 90411 Nürnberg (DE)
(72) Inventor: Doubrava, Michael, 90408 Nürnberg (DE); Fischer, Georg, Dr., 90419 Nürnberg (DE)
(74) Representative: Blumbach Zinngrebe

(57) **Abstract**

The invention relates to a modular RF power amplifier arrangement for a base station for a wireless communication system.

It is an object to provide a modular amplifier arrangement which is upgradeable multiply in a fail-safe manner to increase its output power capabilities in a cost-efficient manner, with low losses, high efficiency.

According to the invention a modular traveling wave amplifier is proposed comprising a basic amplifier module (100) with an input line arrangement (110) and an output line arrangement (120), at least a first branching line (136) for parallely connecting a first upgrade amplifier module (200), and variable or reconfigurable impedance matching means at the input and/or at the output.

## Description

### Field of the Invention

The invention relates to a modular amplifier arrangement in general and to a modular RF power amplifier arrangement for a base station for a wireless communication system in particular.

### Background of the Invention

Base stations for mobile communication systems or networks are typically equipped with radio frequency (RF) power amplifiers to amplify the signal to be transmitted. Typical frequencies are around 900 MHz and 1800 GHz for the GSM standard and around 1900 MHz and 2100 MHz for the UMTS standards.

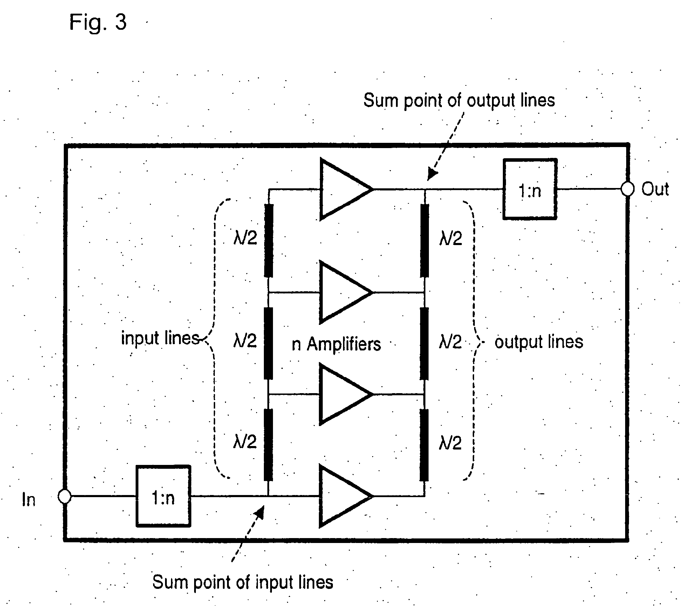

Generally a parallel amplifier architecture as shown in Fig. 3 is known and is described e.g. in Steve Cripps "RF power amplifiers for wireless communication", Artech House, ISBN 0890069891. This architecture is known as traveling wave amplifier. The structure of the traveling wave amplifier comprises a fixed matching network which is designed for a fixed desired transformation ratio. However, this traveling wave amplifier is not suited for an upgrade.

However, it may be desirable to enable an upgrade of the amplifier or base station later to increase the maximum output power when an increased power of the base station is needed.

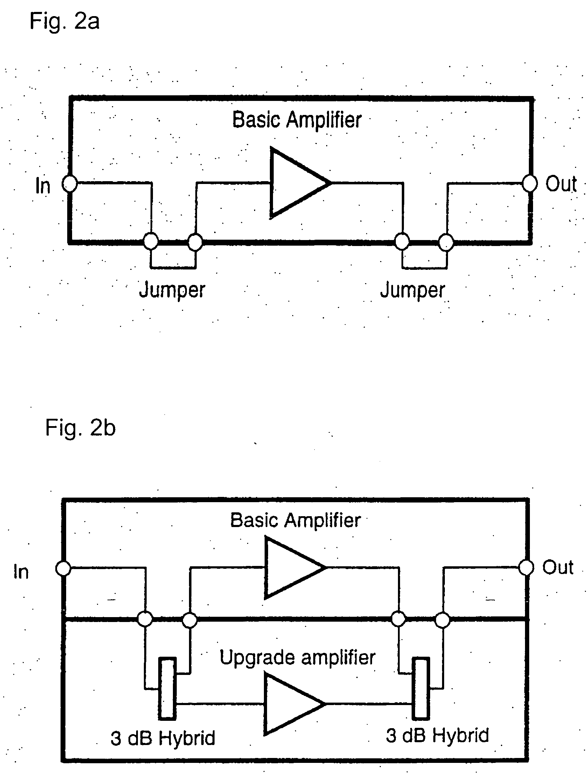

An upgradeable amplifier architecture as depicted in Fig. 2a and 2b is known to the inventors. However, such amplifier architecture suffers from a plurality of disadvantages.

A major shortcoming of such an amplifier architecture is, that the initial amplifier as shown in Fig. 2a comprises four additional upgrade connectors and is equipped with two bridges. Looking at the output of the amplifier there is a considerable RF loss at the connectors and the bridges, thereby disadvantageously degrading the amplifier efficiency.
The upgrade is further problematic, as the input line as well as the output line are equipped with a hybrid coupler as shown in Fig. 2b. The hybrid couplers disadvantageously introduce further losses as well as further connections having losses. Consequently, the effective usable efficiency of the amplifier decreases.

Another disadvantage is, that merely one upgrade is possible with this architecture. If, after the basic amplifier and a first upgrade are assembled, a further upgrade is desired, the hybrid couplers have to be thrown away. This is contrary to the demand for investment protection.

Furthermore due to the nature of hybrid couplers it is merely possible to put 2, 4, 8, ... 2ⁿ amplifiers in parallel. It appears to be not possible with such hybrid combiners to put an odd number of amplifiers, e.g. three, in parallel, resulting in an inflexible approach.

A further drawback is, that the modules for the first and second upgrade have a different design, at least as long as the hybrid combiners are included inside the upgrade module. On the other hand if one would put the hybrid combiners outside the upgrade module, the problem arises that the number of connectors increases further and the RF cabling becomes very complex, resulting in an increased risk of a wrong cabling.

Further disadvantageously, the afore-mentioned system necesitates an intensive modifying of the RF signal chain, especially the RF cabling. However, doing extensive modifications to the RF cabling is dangerous as accidentally wrong connections could be made by the user.

Furthermore having a lot of jumper cables and combiners to put into the RF signal chain causes additional losses at connectors and cables and thus degrades the overall amplifier efficiency.

An essential problem is that precautions for later upgrades are built into the amplifier system. Those cause RF losses and additional cost. This is especially problematic, when an upgrade is never done, because the precautions cause a waste of energy and unnecessary costs for the entry version.

### Summary of the Invention

Therefore, it is an object of the present invention to provide a modular amplifier arrangement which is upgradeable to increase its output power capabilities in a cost-efficient manner.

A further object of the invention is to provide a modular amplifier arrangement with low losses and high efficiency.

Still a further object of the invention is to provide a modular amplifier arrangement which can be upgraded easily and fail-safe, reducing the risk of wrong cabling.

Still a further object of the invention is to provide a modular amplifier arrangement which is flexibly and repeatedly upgradeable.

Still a further object of the invention is to provide a modular amplifier arrangement which avoids or at least ameliorates the disadvantages of prior art amplifiers.

The object of the invention is achieved in a surprisingly simple manner by subject matter of the independent claims. Preferred embodiments of the invention are subject of the subclaims.

According to the invention, a modular RF power amplifier arrangement, in particular for a basestation for a wireless communication system is provided. The amplifier arrangement comprises a basic amplifier module with an input for feeding in signals to be amplified, an output for transmitting signals, e.g. to an antenna, a basic amplifier arranged on or at said basic amplifier module, an input line arrangement connecting the input with the basic amplifier and/or an output line arrangement connecting the basic amplifier with the output.

Furthermore, the basic amplifier module comprises at least a first branch or ramification in said input and/or output line arrangement with a first branching line for parallely connecting a first upgrade amplifier module.

In other words, said first branching line provides a Tee branch at said input or output line arrangement or before or behind said basic amplifier, wherein said Tee branch is provided at or on said basic amplifier module.

Advantageously, the architecture of the modular amplifier arrangement is prepared for at least one or more later upgrades and already includes the lines for combining at the basic amplifier module. As those lines are typically cheap and can be made to have low loss, negative impact on costs and efficiency on the basic amplifier is avoided, in particular, before an upgrade is done.

Preferably, said first branching line connects said input line arrangement with a first port for connecting an input of a first upgrade amplifier module. Further preferably said basic amplifier module comprises a second branching line which connects said output line arrangement with a second port for connecting an output of said first upgrade amplifier module, said second branching line providing a Tee branch behind said basic amplifier.

By this, an RF power amplifier of said first upgrade amplifier module can be connected parallely to said basic RF power amplifier very easily, increasing the output power capabilities of the amplifier arrangement, without having to modify the RF signal chain especially the RF cabling intensively.

Therefore, the amplifier arrangement according to the invention is fail-safe to use and to upgrade. Furthermore, RF losses are largely avoided, increasing the efficiency of the arrangement. Further advantageously, an unnecessary overhead is avoided. The basic amplifier module merely includes some further RF lines and ports or connectors as a matter of precaution for the later upgrade. This ensures low complexity and costs. In particular, when an upgrade is never done, costs are saved.

According to a preferred embodiment, said first branching line has a length of about λ/4 + n * λ/2, wherein n is zero or a positive integer. Preferably the length is λ/4, i.e. n = 0. λ is the mean wavelength of the transmission signal to be amplified by said modular amplifier arrangement for which said modular amplifier arrangement is adapted to. Typical frequencies corresponding to said wavelength are 0,5 to 3 or 6 GHz or even more. It is known to those skilled in the art that todays frequencies for TDMA networks according to the GSM standard are about 900 MHz and 1800 MHz and frequencies for CDMA networks according to the UMTS standard are about 1950 MHz and 2150 MHz.

Preferably said first and/or second branching line are terminated by a short circuit at the respective port, when no upgrade amplifier module is connected to said basic amplifier module. This avoids unwanted radiation from the ports or connectors.

The use of quarter wavelength lines to the ports or connectors is advantageous, as said first and/or second branching line each serves as a gyrator, so that said short circuit transforms into an open circuit at the input line arrangement or at the output line arrangement, respectively, when no upgrade amplifier module is connected to said basic amplifier module. Consequently, undesired losses are avoided.

Further advantageously a plurality of upgrade ports can be provided, by said input line arrangement and/or said output line arrangement comprising a plurality of serial input lines and/or a plurality of serial output lines, respectively. Furthermore, said basic amplifier module comprises a plurality of parallel branching lines, which are connected to said input line arrangement and/or said output line arrangement at Tee branches between said serial input lines and/or said serial output lines.

To adapt the RF properties, in particular the impedance at the input and the output of the basic amplifier module, when one or more upgrade modules are connected, said basic amplifier module preferably comprises variable or reconfigurable impedance matching means at the input and/or at the output a first one between the input and the input line arrangement and a second one between the output and the output line arrangement.

Therewith any impedance change, when adding upgrade amplifier modules with further parallel amplifiers, is addressed by the fact, that the input and output RF port are equipped with the impedance matching matching means or an adaptive matching circuit which can transform nearly every impedance to a desired impedance, in particular to the nominal reference impedance of e.g. 50 Ohm. Therewith, the variation of the impedance at the sum point of the input lines and the output lines caused by the parallel connection of upgrade amplifiers can be compensated.

This technique of adaptive matching is described in more detail in the two patent applications "Amplifier assembly with an adjustable performance" and "Parallel Amplifier Arrangement" of the same applicant filed at the same day as this present application, which two applications are incorporated by reference herewith in their entirety.

Said first upgrade amplifier module preferably comprises an input connected to said first port of said basic amplifier module, an output connected to said second port of said basic amplifier module, a first upgrade amplifier arranged between said input and said output of said first upgrade amplifier module, an input line connecting said input of said first upgrade amplifier module with said first upgrade amplifier and/or an output line connecting said first upgrade amplifier with said output of said first upgrade amplifier module. Furthermore, said first upgrade amplifier module preferably comprises a branching line at said output line or at said input line connecting said first upgrade amplifier with a port of said first upgrade amplifier module for connecting a second upgrade amplifier module.

Preferably a predetermined number of further such upgrade amplifier modules can be connected to the amplifier arrangement. Furthermore, said upgrade amplifier modules are preferably exchangeable with each other and/or have identical inputs and outputs and/or are of identical topology or structure.

This is highly advantageous as it reduces the production and storage costs and provides, particularly fail-safe, multiple upgrading capabilities.

Furthermore, the arrangement is very easy to handle with respect to the RF cabling. There are preferably no jumpers or bridges, which have to be opened. It is very obvious for the user what is input and what is output.

To connect said first upgrade amplifier module to said basic amplifier module, the first and second short circuit at the first and second port, respectively, of said basic amplifier module are removed and said first upgrade amplifier module is connected with said basic amplifier module by connecting said first and second port of said upgrade amplifier module with the first and second port of the basic amplifier module, respectively.

Each further upgrade amplifier module is equivalently connected with one port to the basic amplifier module and with one port to the previous upgrade amplifier module.

Therewith, nothing of the basic amplifier module or the upgrade amplifier modules has to be thrown away when the arrangement is upgraded.

A further benefit of the arrangement according to the invention is that all upgrade modules look the same, because the modules for the first, second and third, preferably and further all upgrades are identical.

Furthermore, the architecture offers a great flexibility in terms of scaleability.

According to a preferred embodiment, said input line, said output line and/or said branching line of said first and/or further upgrade amplifier module have a length of about λ/4 + n * λ/2, wherein n is zero or a positive integer, preferably zero. By this, two of the λ/4 lines of the upgrade amplifier modules add to λ/2 lines together with the respective λ/4 lines of the previous module and the third λ/4 line is terminated with a short circuit again serving as a gyrator.

Furthermore, the architecture of the modular amplifier arrangement or device having such parallel identical stages or branches ensures that the propagation time through the parallel branches is substantially equal. This means that the group delay of a signal, taking the different parallel paths through the parallel branches of the arrangement is substantially identical, or in other words resulting in the same group delay from the input to the output. As the lines or RF lines of λ/2 and λ length also provide very low losses, the parallel amplifiers are excited by substantially the same amount and deliver identical output power.

Consequently, said modular amplifier arrangement represents a modular traveling wave amplifier arrangement or device, when said upgrade amplifier modules are connected to said basic amplifier module, providing a parallel signal amplification.

The invention is described in more detail and in view of preferred embodiments hereinafter. Reference is made to the attached drawings wherein same and similar elements are denoted with the same reference signs.

### Brief Description of the Figures

It is shown in
- Fig. 1a: a schematic diagram of the modular amplifier arrangement before the first upgrade, consisting only of the basic amplifier module,
- Fig. 1b: a schematic diagram of the modular amplifier arrangement after the first upgrade,
- Fig. 1c: a schematic diagram of the modular amplifier arrangement after the second upgrade,
- Fig. 1d: a schematic diagram of the modular amplifier arrangement after the third upgrade,
- Fig. 1e: a schematic diagram of a second embodiment of the modular amplifier arrangement,
- Fig. 2a: a schematic diagram of an classical amplifier before upgrading,
- Fig. 2b: a schematic diagram of an classical amplifier after upgrading and
- Fig. 3: a schematic diagram of a travelling wave amplifier.

### Detailed Description of the Invention

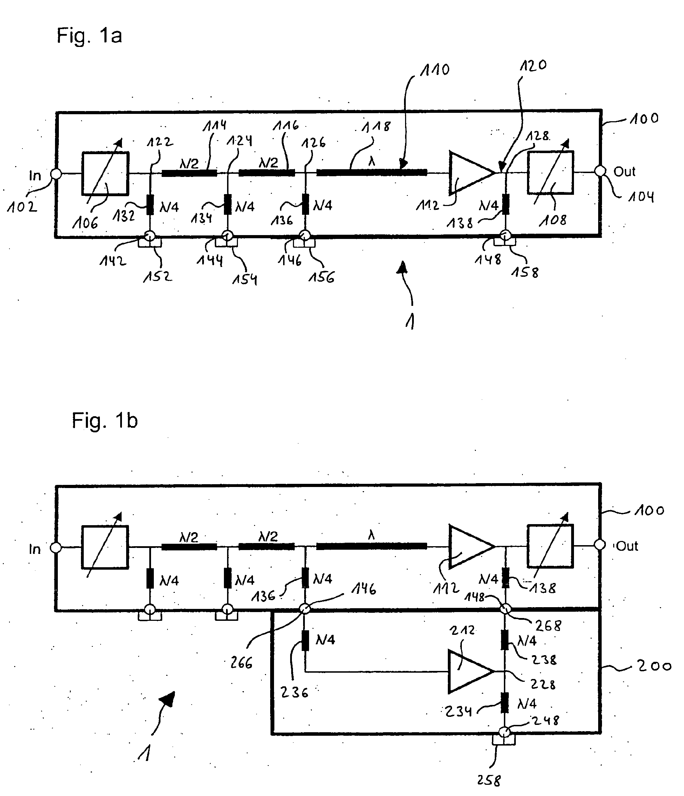

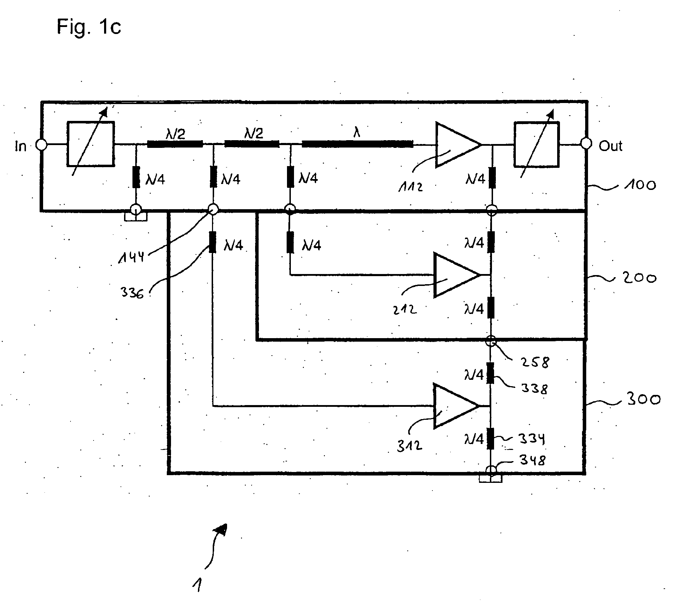

Fig. 1a shows a basic amplifier module 100 with an input 102 and an output 104. Behind the input 102 and before the output 104 each an adjustable or flexible matching is provided by variable or reconfigurable impedance matching means 106 and 108, respectively.

An input line arrangement 110 connects said impedance matching means 106 with a basic amplifier 112. The basic amplifier 112 is connected by an output line arrangement 120 with the impedance matching means 108.

In this example said input line arrangement 110 comprises or consists off a first, second and third input line 114, 116 and 118 for providing three upgrade opportunities. Said first and second input lines 114, 116 are λ/2 lines, wherein said third serial input line 118 is of length λ, wherein λ is the mean guided wavelength of the signal to be amplified.

Between said impedance matching means 106 and said serial input lines 114, 116 and 118 three Tee branches 122, 124 and 126 are provided. The Tee branches are simple electrical nodes without impedance transformation means.

Each of the three subsequent T-branches 122, 124, 126 is connected with an output port 142, 144, 146 by one λ/4 branching line 132, 134 and 136, respectively.

A further Tee branch 128 is provided in said output line arrangement 120 which Tee branch 128 is connected to a further port 148 by a λ/4 branching line 138. It is clear, that a further serial output line (not shown), preferably of λ/2 length, may be provided between the basic amplifier 112 and the impedance matching means, before and/or behind the Tee branch 128. A line of any multiple of λ/2 length can be considered as transparent from the impedance transformation perspective.

All ports 142, 144, 146, 148 are terminated with a short circuit 152, 154, 156 and 158, respectively.

Therewith, the λ/4 lines 132, 134, 136, 138 serve as gyrators. This means that the short circuits at the ports are transformed into open circuits at the input and output line arrangements 110, 120. Consequently, the input and output lines are substantially not loaded with additional parallel impedance.

A difficulty is, that this gyrator behavior works only ideal for one exact frequency. With broadband amplifiers the short circuits will not always be transformed into open circuits, sometimes there will be parallel capacitances or inductances. In general, it can be said, that the λ/4 lines cause additional impedance variation over a wide band.

However, this impedance detuning is overcome by adaptive matching using the impedance matching means or cicuits 106, 108 at the input and output 102, 104. These impedance matching circuits 106, 108 ensure an optimal match over a wide frequency range.

Besides the effect that the short circuits avoid unwanted radiation from connectors, the λ/4 lines also serve as harmonic filters. They look like short circuits for twice the operating frequency and by that terminate unwanted harmonics.

This architecture substantially avoids to degrade the efficiency of the arrangement, as the additional RF lines and connectors substantially do not cause significant losses.

Referring to Fig. 1b, the modular amplifier arrangement 1 comprising the basic amplifier module 100 and a first upgrade amplifier module 200 is shown.

The short circuits or shorts 156 and 158 are removed to connect the first upgrade amplifier module 200 to the basic amplifier module 100 by connecting the ports 146 and 148 with mating ports 266, 268 of the first upgrade amplifier module.

The first upgrade amplifier module 200 comprises an input line 236 of λ/4 length connecting the port 266 with an upgrade amplifier 212, which is in turn connected with an output line 238 of λ/4 length at its output connected with the port 268.

Therewith, λ/4 lines 136 and 236 add to a λ/2 line as well as λ/4 lines 138 and 238, when the first upgrade amplifier module 200 is connected to the basic amplifier module 100, providing a low loss signal transmission and avoid different group delay for the two parallel amplifying signal paths.

Furthermore, at the output of the upgrade amplifier 212 a Tee branch 228 is provided, which is connected by a λ/4 branching line 234 with a port 248 which is provided to enable a second upgrade, but is terminated with a short circuit 258 in this state shown in Fig. 1b.

By this architecture, the use of hybrid couplers in the upgrade modules can be avoided.

Referring to Fig. 1c the modular amplifier arrangement 1 with a second upgrade amplifier module 300 is depicted. The second upgrade amplifier module 300 has the same topology as the first upgrade amplifier module 200 and is parallely connected via the ports 144 and 248 to the basic amplifier module 100 and the first upgrade amplifier module 200 with its input and output ports, respectively.

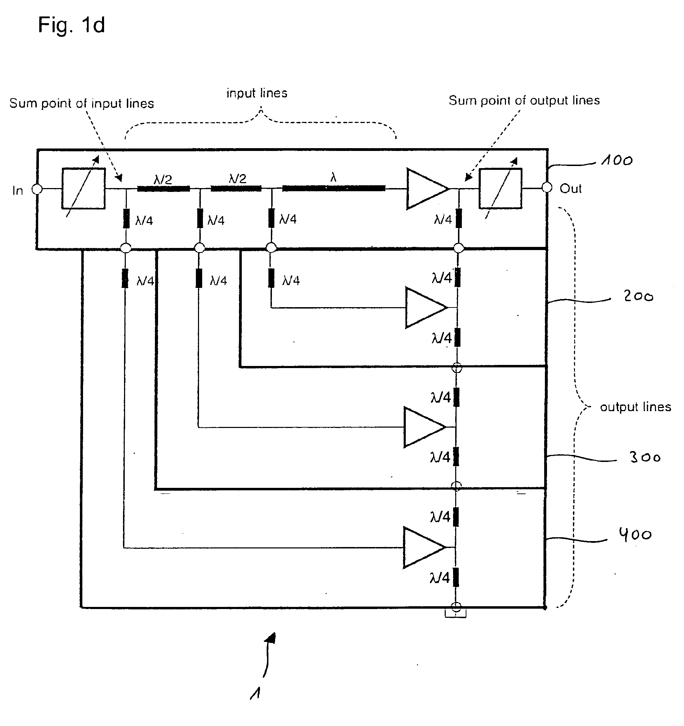

Referring to Fig. 1d the modular amplifier arrangement 1 is shown with a third - and in this example final - upgrade amplifier module 400 having the same topology like the first and second upgrade amplifier modules 200, 300 and being equivalently connected.

The components of the second and third upgrade amplifier modules 300 and 400 are depicted with reference signs having the same second and third digit as the respective components of the first upgrade amplifier module 200, but a "3" and "4", respectively, instead of a "2" as first digit.

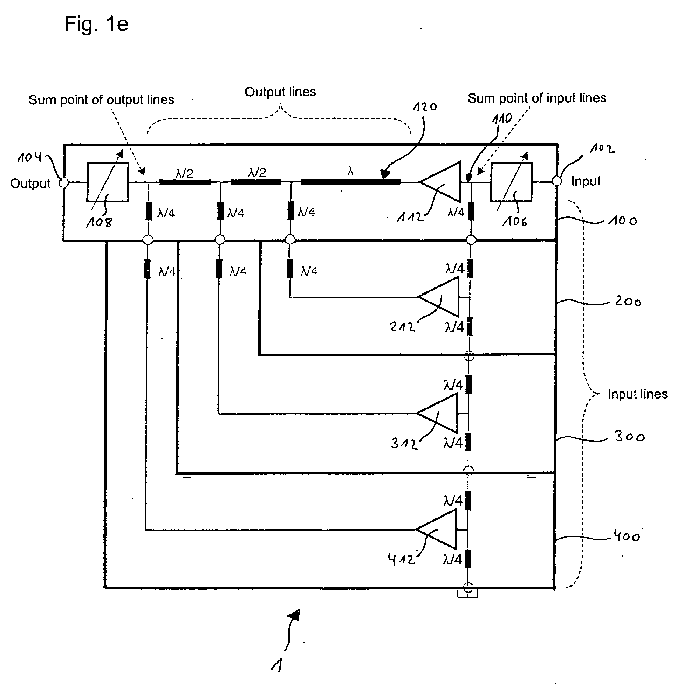

It is clear, that the topology of the modular amplifier 1 can be mirrored with respect to the input and output line arrangements as shown in Fig. 1e.

It can be seen, that the four amplifiers 112, 212, 312 and 412 are provided parallely with the same signal delay, defining a modular traveling wave amplifier arrangement or device, when connected together.

The topology of the traveling wave amplifier with multiway combining has been described by Steve Cripps "RF power amplifiers for wireless communication", Artech House, ISBN 0890069891, which is incorporated by reference, herewith.

It should be noted that, the architecture proposed by this invention may have some difficulties with LDMOS transistors at output power levels, which are typically used for mobile communication basestation. The issue is that LDMOS transistors tend to have very low output impedance in the order of a few Ohms. At such low impedance putting amplifying transistors in parallel at the output may suffer from resistance in the RF lines.

Therefore, it is preferred that the resistance of the RF lines is low compared to the output impedance, as far as possible.

However, those difficulties vanish with new emerging transistor technologies. Upcoming silicon VMOS, SiC and GaN transistors allow for much higher supply voltage up to 120 V, which will deliver an output impedance in the range of 20 to 50 Ohm depending on power capabilities. With such high output impedance the resistance of RF lines and connectors is very low compared to the output impedance.

It is noted, that the invention is not limited to any specific amplifier technology, it is applicable to all amplifier technologies including also non semiconductor based technologies like tubes, optical amplifiers and other technologies. However the implementation effort may vary depending on used technology.

It is obvious that the concept described in this invention is not limited to maximal 4 amplifiers in parallel. The concept is applicable to any number of parallel amplifiers.

Generally, it will be appreciated that the above-described embodiment of the invention has been set forth solely by way of example and illustration of the principles thereof and that further modifications and alterations may be made therein without thereby departing from the spirit and scope of the invention.

## Claims

1. A modular amplifier arrangement (1), in particular for a basestation for a wireless communication system, comprising
a basic amplifier module (100) with an input (102), an output (104), a basic amplifier (112), an input line arrangement (110) connecting the input (102) with the basic amplifier (112) and/or an output line arrangement (120) connecting the basic amplifier (112) with the output (104),
wherein the basic amplifier module (100) comprises at least a first branching line (136) for parallely connecting a first upgrade amplifier module (200).

2. The modular amplifier arrangement (1) of claim 1,
wherein
said first branching line (136) connects said input line arrangement (110) with a first port (146) for connecting an input of a first upgrade amplifier module (200) and said basic amplifier module (100) comprises a second branching line (138) which connects said output line arrangement (120) with a second port (148) for connecting an output of said first upgrade amplifier module (200).

3. The modular amplifier arrangement (1) of one of the preceding claims, wherein
said first branching line (136) has a length of about λ/4 + n * λ/2, wherein n is zero or an integer and
wherein λ is the mean guided wavelength of the transmission signal to be amplified by said modular amplifier arrangement (1).

4. The modular amplifier arrangement (1) of one of the preceding claims, wherein
said first and/or second branching line (136, 138) are terminated by a short circuit (156, 158), when no upgrade amplifier module (200) is connected to said basic amplifier module (100).

5. The modular amplifier arrangement (1) of one of the preceding claims, wherein
said first and/or second branching line (136, 138) serves as a gyrator, when no upgrade amplifier module (200) is connected to said basic amplifier module (100).

6. The modular amplifier arrangement (1) of one of the preceding claims, wherein
said input line arrangement (110) and/or said output line arrangement (120) comprises a plurality of serial input lines (114, 116, 118) and/or a plurality of serial output lines, respectively.

7. The modular amplifier arrangement (1) of one of the preceding claims, wherein
said basic amplifier module (100) comprises a plurality of parallel branching lines (132, 134, 136), which are connected to said input line arrangement (110) or said output line arrangement (120) between said serial input lines (114, 116, 118) or said serial output lines.

8. The modular amplifier arrangement (1) of one of the preceding claims, wherein
said basic amplifier module (100) comprises variable or reconfigurable impedance matching means (106, 108) at the input (102) and/or at the output (104).

9. The modular amplifier arrangement (1) of one of the preceding claims, further comprising at least a first upgrade amplifier module (200) having
an input connectable to said first port (146) of said basic amplifier module (100),
an output connectable to said second port (148) of said basic amplifier module (100),
a first upgrade amplifier (212) arranged between said input and said output of said first upgrade amplifier module (200),
an input line (236) connecting said input of said first upgrade amplifier module (200) with said first upgrade amplifier (212),
an output line (238) connecting said first upgrade amplifier (212) with said output of said first upgrade amplifier module (200), and
a branching line (234) at said output line (238) or at said input line (236) connecting said first upgrade amplifier (212) with a port (248) of said first upgrade amplifier module (200) for connecting a second upgrade amplifier module (300).

10. The modular amplifier arrangement (1) of claim 9,
wherein
said input line (236), said output line (238) and/or said branching line (234) of said first upgrade amplifier module (200) have a length of about λ/4 + n * λ/2, wherein n is zero or an integer.

11. The modular amplifier arrangement (1) of one of the preceding claims further comprising at least a second upgrade amplifier module (300) having
an input connectable to a third port (144) of said basic amplifier module (100),
an output connectable to said port (248) of said first upgrade amplifier module (200),
a second upgrade amplifier (312) arranged between said input and said output of said second upgrade amplifier module (300),
an input line (336) connecting said input of said second upgrade amplifier module (300) with said second upgrade amplifier (312),
an output line (338) connecting said second upgrade amplifier (312) with said output of said second upgrade amplifier module (300) and
a branching line (334) at said output line (338) or at said input line connecting said second upgrade amplifier (312) with a port (348) of said second amplifier module (300) for connecting a third upgrade amplifier module (400).

12. The modular amplifier arrangement (1) of one of the preceding claims, wherein
said first and second upgrade amplifier module (200, 300) have an identical topology and/or wherein further upgrade amplifier modules (400) having an identical topology are provided and/or wherein said modular amplifier arrangement represents a modular traveling wave amplifier device, when said upgrade amplifier modules (200, 300, 400) are connected to said basic amplifier module (100).

13. Basic amplifier module (100) adapted for the modular amplifier arrangement (1) of one of the preceding claims, comprising
an input (102),
an output (104),
a basic amplifier (112),
an input line arrangement (110) connecting the input (102) with the basic amplifier (112) and/or
an output line arrangement (120) connecting the first amplifier (112) with the output (104) and
at least a first branching line (136) for parallely connecting a first upgrade amplifier module (200).

14. Upgrade amplifier module (200, 300, 400) adapted for the modular amplifier arrangement (1) of one of the preceding claims, comprising
an input connectable to said first port (146) of said basic amplifier module (100),
an output connectable to said second port (148) of said basic amplifier module (100),
a first upgrade amplifier (212) arranged between said input and said output of said first upgrade amplifier module (200),
an input line (236) connecting said input of said first upgrade amplifier module (200) with said first upgrade amplifier (212),
an output line (238) connecting said first upgrade amplifier (212) with said output of said first upgrade amplifier module (200), and
a branching line (234) at said output line (238) or at said input line (236) connecting said first upgrade amplifier (212) with a port (248) for connecting a second upgrade amplifier module (300).

15. Base station for a wireless telecommunications system or network comprising a modular amplifier arrangement (1), in particular according to one of the preceding claims, wherein said modular amplifier arrangement (1) comprises a basic amplifier module (100) and at least a first upgrade amplifier module (200), being releasably connected together, thereby establishing a traveling wave amplifier device providing a parallel signal amplification with an essentially identical group delay.

16. Method for upgrading a modular amplifier arrangement (1) comprising a basic amplifier module (100), in particular according to one of the preceding claims, comprising the steps of
removing a first short circuit (156) at a first port (146) of said basic amplifier module (100),
removing a second short circuit (158) at a second port (148) of said basic amplifier module (100),
connecting a first upgrade amplifier module (200) having a first and second port with said basic amplifier module by connecting said respective first ports and said respective second ports together.
